**Europäisches Patentamt**

(19) **European Patent Office**

**Office européen des brevets**

(11) Veröffentlichungsnummer: **0 053 107**
**B1**

(12) ## EUROPÄISCHE PATENTSCHRIFT

(45) Veröffentlichungstag der Patentschrift:
**23.01.85**

(51) Int. Cl.⁴: **H 01 J 37/063,** H 01 J 3/02

(21) Anmeldenummer: **80901264.4**

(22) Anmeldetag: **07.06.80**

(86) Internationale Anmeldenummer:
**PCT/DE 80/00086**

(87) Internationale Veröffentlichungsnummer:
**WO 81/03579 (10.12.81** Gazette 81/29)

(54) **VERFAHREN ZUR STEUERUNG EINES ELEKTRONENSTRAHLERZEUGERS HOHER KONSTANZ FÜR MATERIALBEARBEITUNG.**

(43) Veröffentlichungstag der Anmeldung:
**09.06.82 Patentblatt 82/23**

(45) Bekanntmachung des Hinweises auf die Patenterteilung:
**23.01.85 Patentblatt 85/4**

(84) Benannte Vertragsstaaten:
**CH DE FR GB LI NL**

(56) Entgegenhaltungen:
**FR - A - 2 114 205**

**Zeitschrift für angewandte Physik, 3. Band, 1951 Berlin, DE, M. Ploke "Elementare Theorie der Elektronenstrahlerzeugung mit Triodensystemen", Seiten 441-449**

(73) Patentinhaber: **DR.-ING. RUDOLF HELL GmbH, Grenzstrasse 1-5, D-2300 Kiel 14 (DE)**

(72) Erfinder: **BEISSWENGER, Siegfried, Albert-Einstein-Strasse 22, D-2308 Preetz (DE)**

## Beschreibung

Die Erfindung betrifft einen Elektronenstrahlerzeuger hoher Konstanz für die Materialbearbeitung mit einer elektrisch beheizten Kathode, einer durchbohrten Anode und einer auf negativerem Potential als die Kathode liegenden und zwischen Kathode und Anode angeordneten Steuerelektrode.

Bei dem bekannten Elektronenstrahlerzeugungssystem zur Materialbearbeitung wird der Elektronenstrahl durch 3 Elektroden erzeugt und geregelt, Kathode, durchbohrte Anode und Wehneltzylinder. Als Kathoden werden direkt und indirekt geheizte H-Nadel-, Band- oder Bolzenkathoden aus Wolfram sowie Kathoden aus Lanthanhexaborat eingesetzt.

Die Elektronen des Elektronenstrahls werden durch die Heizung aus der Kathode emittiert und anschließend beschleunigt. Es kann z. B. die Kathode mit einer hohen negativen Spannung beaufschlagt sein, während die Anode auf Erdpotential liegt. In dem so erzeugten elektrischen Feld werden die Elektronen zur Anode hin beschleunigt, durchsetzen die Anodenbohrung und gelangen in den feldfreien Raum.

Aus der FR-A-2 114 205 ist ein Elektronenstrahlerzeugungssystem bekannt, bei dem die Kathode von einer Blende umgeben ist, die als gelochte Scheibe ausgebildet ist. Die Blende ist auf Kathodenpotential gelegt und verhindert, daß die seitlich aus der Kathode austretenden Elektronen zum Strahl beitragen.

Dieses System weist eine Fokus-Elektrode auf, die, wenn sie positiv gegenüber der Kathode vorgespannt ist, als Anode arbeitet. Eine Steuer- oder Wehneltelektrode ist nicht vorgesehen, so daß eine Regelung des Strahlstroms nicht möglich ist.

Bei den weiterhin bekannten Systemen dient die dritte Elektrode, die Wehnelt- oder Gitterelektrode, zur Stromsteuerung des Strahls. Die Funktion der Wehnelt-Elektrode ist z. B. in der Druckschrift M. Blocke, Zeitschrift für angewandte Physik, dritter Band, 1951, Seiten 441 bis 449, »Elementare Theorie der Elektronenstrahlerzeugung mit Triodensystemen« beschrieben.

Wird die negative Spannung der Wehneltelektrode über einen bestimmten Wert gesteigert, so können keine Elektronen mehr die Kathodenoberfläche verlassen, d. h. es gibt an der Kathodenoberfläche keine auf die Anode gerichteten elektrischen Feldvektoren, welche die Elektronen zur Anode hin beschleunigen. Die Emission ist gesperrt. Wird die Wehnelt-Spannung erniedrigt, so erhöht sich der Anodendurchgriff. Mit sinkender Wehnelt-Spannung werden immer größere Bereiche der Kathode zur Emission freigegeben, wodurch der Emissionsstrom ansteigt. Die einstellbare negative Spannung des Wehnelt-Zylinders gegenüber der Kathode erlaubt somit eine Steuerung des Strahlstroms.

Eine Eigenart dieser Systeme ist im folgenden näher beschrieben. Es ergibt sich aus der baulichen Anordnung von Wehnelt-Zylinder und durch die vorgegebene Wehnelt-Spannung, die zur Einstellung eines gewünschten Strahlstroms erforderlich ist, eine feste Strahlgeometrie, die nur durch Änderung der Bauform oder der Wehnelt-Spannung veränderbar ist. Eine Veränderung der Wehnelt-Spannung führt aber wiederum zu einer Änderung des Strahlstroms. Diese starre Abhängigkeit des Strahlstroms von der Wehnelt-Spannung und die durch die Wehneltanordnung und Wehnelt-Spannung feststehende Strahlform sind nachteilig.

Hinzu kommt als weiterer Nachteil, daß bei der üblichen Betriebsweise die Kathode im Raumladungsbereich betrieben wird, wodurch der Richtstrahlwert unter dem Wert liegt, der sich theoretisch bei Betrieb der Kathode im Sättigungsbereich ergeben würde. Hieraus resultiert, daß die Leistungsfähigkeit des Elektronenstrahlerzeugers nicht den optimal erreichbaren Wert annimmt.

Der vorliegenden Erfindung liegt daher die Aufgabe zugrunde, einen Elektronenstrahlerzeuger zu schaffen, der diese Nachteile nicht aufweist und einen gegenüber bekannten Elektronenstrahlerzeugern höheren Richtstrahlwert hat.

Die Erfindung besteht also in einem Verfahren zur Steuerung eines Elektronenstrahlerzeugungssystems mit einer beheizten Kathode, einer durchbohrten Anode und einer auf negativerem Potential als die Kathode liegenden Hilfselektrode und ist dadurch gekennzeichnet, daß die Strahlgeometrie durch Anlegen eines konstanten und gegenüber dem Kathodenpotential negativeren Potentials an die Hilfselektrode und die Strahlintensität durch die geregelte Heizung der Kathode auf eine konstante Temperatur bestimmt sind.

Eine vorteilhafte Weiterbildung besteht darin, daß die Hilfselektrode die Kathode umgibt und auf geringfügig negativerem konstanten Potential als die Kathode liegt. In vorteilhafter Weise ist die Hilfselektrode als eine die Kathode umgebende gelochte Scheibe ausgebildet und der Aufbau so getroffen, daß die zur Anode weisende Oberfläche der Hilfselektrode mit der zur Anode weisenden Oberfläche der Kathode fluchtet.

Die Erfindung wird im folgenden anhand der Fig. 1—3 näher erläutert. Es zeigt

Fig. 1 ein Beispiel für die Anordnung der Elektroden des Elektronenstrahlerzeugungssystems und für die Strahlgeometrie des Elektronenstrahls,

Fig. 2 ein weiteres Beispiel für die Strahlgeometrie des Elektronenstrahls und

Fig. 3 eine Schaltungsanordnung für die Heizung der Kathode.

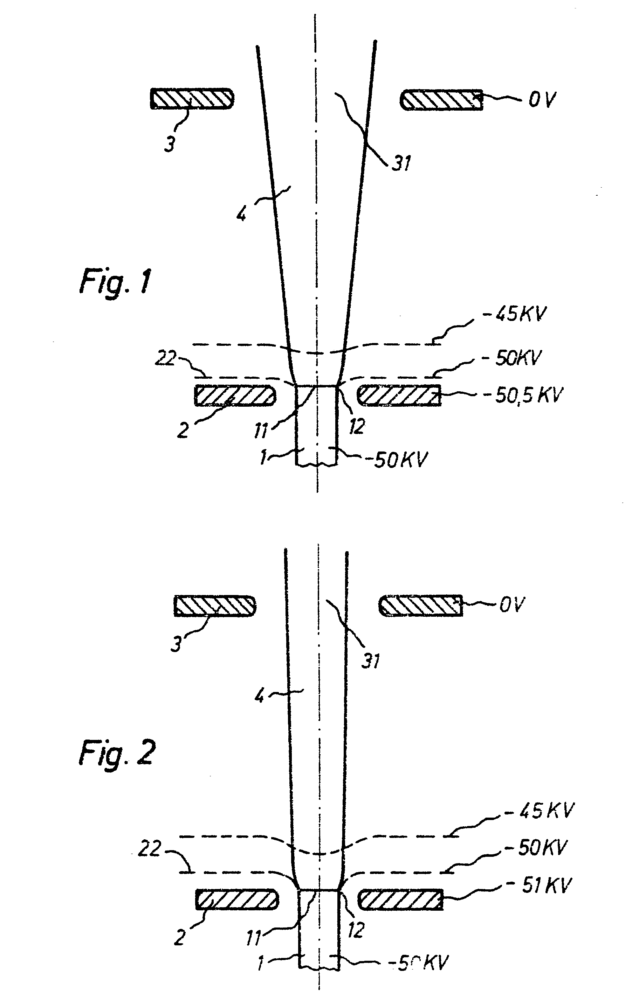

In Fig. 1 ist eine schematisch dargestellte Kathode 1 von einer ringförmigen Hilfselektrode 2 umgeben. Die Hilfselektrode 2 liegt auf etwas negativerem Potential als die Kathode 1. Wird die Kathode 1 beheizt, so emittiert sie vornehmlich aus ihrer Oberfläche 11 einen Elektronenstrahl 4, der sich in Richtung einer durchbohrten Anode 3 bewegt und durch die Anodenbohrung 31 hindurchtritt.

An den einzelnen Elektroden mögen etwa folgende Spannungen anliegen:

| | |
|---|---|
| Kathode | −50 KV, |
| Hilfselektrode | 50,5 KV |
| und Anode | 0 V. |

Mit der Bezugszahl 22 ist eine Äquipotentialfläche für das Potential der Kathodenoberfläche bezeichnet, und man erkennt, daß sie vom Rand 12 der Kathodenfläche 11 leicht ansteigt, um über der Hilfselektrode 2 wieder einen konstanten Verlauf anzunehmen. Hierdurch wird erreicht, daß keine Elektronen, die aus den seitlichen Flächen der Kathode austreten, zum Strahl beitragen.

Durch diese Anordnung von Kathode und Hilfselektrode kann im Zusammenhang mit der Beheizung der Kathode auf konstanter Temperatur eine optimale Leistungsausnutzung des Systems erreicht werden, wobei zusätzlich der Einfluß der Hilfselektrode 2 als freier Parameter für die Strahlformung nutzbar wird, was im folgenden näher erläutert wird.

Durch den in Fig. 1 angegebenen Potentialverlauf ist es möglich, die Kathode in der Sättigung zu betreiben. Es werden dann alle Elektronen direkt von der Kathodenoberfläche abgesaugt, da die Potentialdifferenz zwischen Kathode und Anode ein elektrisches Feld erzeugt, das nahezu ungeschwächt an der Kathodenoberfläche wirksam wird.

Es bildet sich nicht wie bei bekannten Anordnungen eine Raumladungszone oberhalb der Kathode aus. Der Grund für diese Raumladungszone bei bekannten Anordnungen liegt darin, daß bei nicht genauer Bemessung der Emissionsfläche der Kathode es zur Strahlstromsteuerung erforderlich ist, ein vergleichweise hohes negatives Potential an die Wehneltelektrode zu legen. Dadurch wird die absaugende Feldstärke vor der Kathode stark vermindert. Es bildet sich in diesem Falle vor der Kathode eine Raumladungszone aus Elektronen aus. Die anodenseitige Oberfläche dieser Raumladungszone wirkt nun als eigentliche Elektronenquelle. Da die Emissionsfläche der Raumladungszone immer größer ist als die aktive Fläche der Kathode selbst, ist die Emissionsdichte bei diesen Systemen geringer, d. h. der Richtstrahlwert ist schlechter.

Fig. 2 zeigt ein Beispiel, wie bei Beibehaltung der optimalen Ausnutzung der Strahlenergie eine veränderte Formung des Strahls durch die Hilfselektrode 2 erfolgt. Da es sich in Fig. 2 um dieselben Bauteile wie in Fig. 1 handelt, sind dieselben Bezugszahlen verwendet worden. Im Unterschied zur Fig. 1 ist das Potential der Hilfselektrode 2 etwas negativer gewählt, und zwar beispielsweise zu −51 KV. Man erkennt, daß der Verlauf der −50 KV Linie 22 zwischen Kathode und Hilfselektrode steiler verläuft als in Fig. 1. Dies führt dazu, daß die aus der Kathode austretenden Elektronen zu einem schlankeren Elektronenstrahl gebündelt werden.

Es ist also durch die Einstellung der Spannung der Hilfselektrode auf einfache Weise möglich, die Strahlgeometrie des Elektronenstrahls zu verändern, ohne daß die Stromstärke des Strahls verändert wird.

Der Emissionsstrom einer Kathodenfläche von einer bestimmten Größe hängt im Sättigungsbetrieb nur von der Kathodentemperatur ab. Um daher im vorliegenden Falle eine bestimmte Stromstärke des Elektronenstrahls einzustellen, wird die Kathodenheizleistung so geregelt, daß die Kathode konstant die zur gewünschten Stromstärke gehörige Temperatur besitzt.

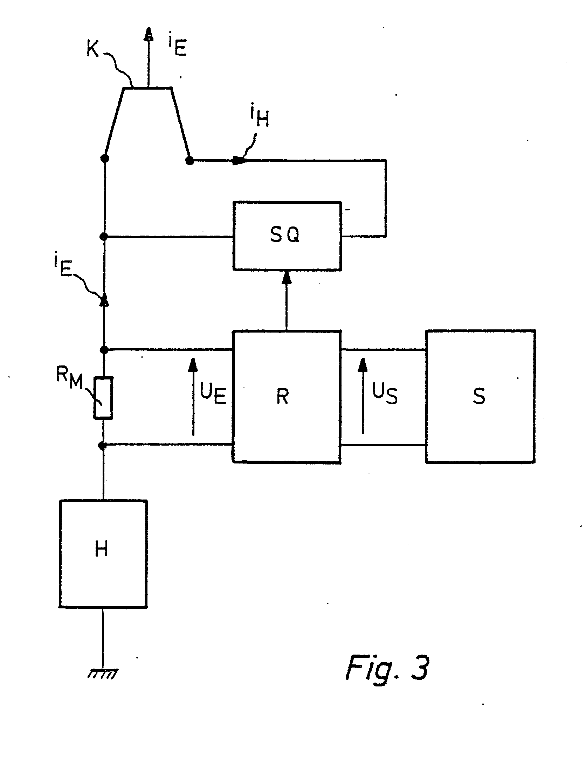

In der Fig. 3 ist für das Beispiel einer direkt beheizten Kathode eine schematische Schaltung zur Konstanthaltung der Kathodentemperatur angegeben.

Der Emissionsstrom $i_E$ fließt vom Hochspannungsgenerator H über den Strommeßwiderstand RM zur Kathode K. Am Meßwiderstand fällt die dem Emissionsstrom proportionale Spannung UE ab. Im Sollwertgeber S wird eine dem gewünschten Strahlstrom proportionale Spannung US erzeugt. Die Spannungen US und UE werden dem Regler R zugeführt. Der Regler R stellt die Spannungsquelle SQ des Heizstromkreises der Kathode K so ein, daß UE = US wird, d. h. die Kathode emittiert den konstanten Strom $i_E$, wobei wegen des eindeutigen Zusammenhangs zwischen dem Emissionsstrom und der Kathodentemperatur eine konstante Kathodentemperatur eingehalten wird.

Ein weiterer Vorteil der Erfindung wird durch einen Vergleich mit einem herkömmlichen System deutlich:

Da bei einem herkömmlichen System der Strahlstrom mittels der Wehneltspannung gesteuert wird, muß die Heizleistung so eingestellt werden, daß die Kathode eine höhere Temperatur einnimmt, als es zur Erzielung des gewünschten Strahlstroms notwendig wäre. Nun ändert sich während der Kathodenlebensdauer der Kathodenwiderstand RK durch Abdampfen von Kathodenmaterial. Wird die Kathode stromkonstant geheizt, so erhöht sich die Kathodenheizleistung und damit die Kathodentemperatur ständig gemäß der Gleichung für stromkonstante Heizleistung $N_H$

$$N_H = i_H^2 \cdot R_K$$

Entsprechend erniedrigt sich die Kathodentemperatur mit der Heizleistung bei spannungskonstanter Heizung gemäß der Gleichung

$$N_H = U_H^2/RK$$

Die Änderung der Kathodentemperatur infolge von Alterung bedingt jedoch eine Änderung der Emissionsfähigkeit der Kathode. Nun kann zwar durch eine Regelung der Wehneltspannung ein konstanter Strahlstrom eingehalten werden, aber gleichzeitig bewirken die notwendigen Veränderungen der Wehneltspannung eine Veränderung der Strahlgeometrie.

Diese Nachteile werden in der erfindungsgemäßen Anordnung vermieden, da die zur Erzielung einer günstigen Strahlform einmal eingestellte Wehneltspannung nicht verändert wird, da die Heizleistung während der Kathodenlebensdauer so geregelt wird, daß die Kathode immer dieselbe Temperatur besitzt.

Gewerbliche Verwertbarkeit

Die Erfindung kann mit Vorteil bei der Materialbearbeitung mit Elektronenstrahlen verwendet werden, bei der es auf eine hohe Energiedichte und eine präzise Strahlform ankommt.

Ein weiteres Anwendungsgebiet liegt in der Herstellung von Druckformen mittels Elektronenstrahl, wobei aus der Oberfläche der Druckform mit dem Elektronenstrahl die für den Druckvorgang erforderlichen Näpfchen graviert werden.

Außerdem kann die Erfindung bei der Elektronenstrahlmikroskopie angewendet werden.

**Patentansprüche**

1. Verfahren zur Steuerung eines Elektronenstrahlerzeugungssystems mit einer beheizten Kathode (1), einer durchbohrten Anode (3) und einer die Kathode umgebende Hilfselektrode (2), dadurch gekennzeichnet, daß die Strahlgeometrie durch Anlegen eines konstanten, gegenüber dem Kathodenpotential negativeren Potentials an die Hilfselektrode und die Strahlintensität durch geregelte Heizung der Kathode auf konstanter Temperatur bestimmt sind.

2. Elektronenstrahlerzeugungssystem zur Durchführung des Verfahrens nach Anspruch 1, dadurch gekennzeichnet, daß die Hilfselektrode eine die Kathode umgebende gelochte Scheibe ist.

3. Elektronenstrahlerzeuger nach Anspruch 2, dadurch gekennzeichnet, daß die zur Anode weisende Oberfläche der Kathode mit der zur Anode weisenden Oberfläche der Hilfselektrode fluchtet.

**Claims**

1. Method for controlling an electron beam generation system comprising a heated cathode (1) a transpierced anode (3) and an auxiliary electrode (2) surrounding the cathode, characterised in that the beam geometry is determined by application of a constant potential more negative than the cathode potential to the auxiliary electrode, and that the beam intensity is determined by regulated heating of the cathode at constant temperature.

2. Electron beam generation system for application of the method according to claim 1, characterised in that the auxiliary electrode is a perforated plate surrounding the cathode.

3. Electron beam generator according to claim 2, characterised in that the cathode surface turned towards the anode extends flush with the auxiliary electrode surface facing towards the anode.

**Revendications**

1. Procédé pour commander un système générateur à faisceau d'électrons avec une cathode chauffée (1), une anode percée (3) et une électrode auxiliaire (2) entourant la cathode, caractérisé en ce que la géométrie du faisceau est déterminée par application d'un potentiel constant plus négatif que le potentiel de la cathode, sur l'électrode auxiliaire et on détermine l'intensité du faisceau par un chauffage de la cathode régulé à une température constante.

2. Système générateur de faisceau d'électrons pour la mise en oeuvre du procédé selon la revendication 1, caractérisé en ce que l'électrode auxiliaire est un disque percé entourant la cathode.

3. Générateur de faisceau d'électrons selon la revendication 2, caractérisé en ce que la surface extérieure de la cathode tournée vers l'anode est alignée sur la surface extérieure de l'électrode auxiliaire, dirigée vers l'anode.

Fig. 1

Fig. 2

*Fig. 3*